# EUROPEAN PATENT APPLICATION

(11) **EP 1 179 845 A2**
(43) Date of publication of application: **13.02.2002**
(21) Application number: 01119051.9
(22) Date of filing: 07.08.2001
(51) Int. Cl.: H01L 23/31

(54) **Semiconductor device and manufacturing method thereof**

(30) Priority: 10.08.2000 JP 2000242207
(71) Applicant: NEC CORPORATION, Tokyo (JP)
(72) Inventor: Kanatake, Mitsuhito, Minato-ku, Tokyo (JP)
(74) Representative: Glawe, Delfs, Moll & Partner

(57) **Abstract**

In the present invention, a semiconductor device is provided having a semiconductor chip mounted on a chip mounting part of a lead frame, a resin receiver provided on the side of the rear surface of the chip mounting part, primary sealing resin that seals the semiconductor chip in a range in which the resin receiver is provided so that space is formed between the semiconductor chip and the resin receiver and secondary sealing resin that wraps the primary sealing resin together with the resin receiver and forms double sealed structure.

## Description

### BACKGROUND OF THE INVENTION

### 1. Field of the Invention

The present invention relates to a semiconductor device and its manufacturing method, relates particularly but not limited to a semiconductor device using a punched metallic lead frame and its manufacturing method. The present application is based on Japanese Patent Application No. 242207/2000, which is incorporated herein by reference.

### 2. Background

Heretofore, for a semiconductor device using a metallic lead frame and having a hollow package structure in which the periphery of a semiconductor chip is hollow, a resin sealed semiconductor device (refer to Japanese patent application Laid-open No. Hei 5-291319) using a flexible film base, for example, and a resin sealed high frequency semiconductor device using a molded resin package and its manufacturing method (refer to Japanese patent application Laid-open No. Hei 5-218222) are known.

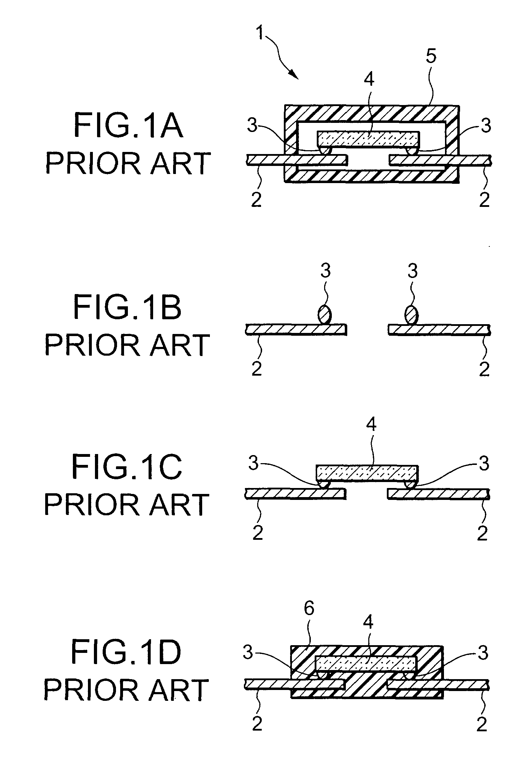

FIGS. 1A to 1B show a semiconductor device provided with a conventional type hollow package structure. FIG. 1A is a sectional view and FIGS. 1B to 1D are process drawings for explaining a manufacturing method. As shown in FIG. 1A, a semiconductor device 1 is provided with a semiconductor chip 4 connected to a metallic lead frame 2 via a bump 3 in flip-chip mounting. The semiconductor chip 4 is sealed in molded resin 5 so that the periphery of the semiconductor chip is in a hollow portion of the molded resin.

When the semiconductor device 1 is manufactured, first, the bump 3 is connected to the lead frame 2 as shown in FIG. 1B and then the semiconductor chip 4 is connected to the lead frame 2 via the bump 3 in flip-chip mounting as shown in FIG. 1C.

Afterward, primary sealing resin 6 is applied to the semiconductor chip 4, and the semiconductor chip 4 and the lead frame 2 around the semiconductor chip are covered with the primary sealing resin 6 as shown in FIG. 1D. Further, the whole primary sealing resin 6 including the semiconductor chip 4 are sealed with the molded resin 5.

At this time, the primary sealing resin 6 is melted by heat in the sealing step, and is thus absorbed in the molded resin 5 and the periphery of the semiconductor chip 4 is made hollow as shown in FIG. 1A.

However, in the semiconductor device 1 provided with the hollow package structure, a surface active part of the semiconductor chip 4 is often contaminated by the primary sealing resin 6 and in case the surface active part is contaminated, the deterioration of a high frequency characteristic cannot be avoided.

The reason for this deterioration is that the primary sealing resin 6 is absorbed by the molded resin 5 in a secondary sealing process, and the melted primary sealing resin 6 is left on the surface of the semiconductor chip 4 without being completely absorbed. The primary sealing resin 6 is absorbed when it is heated again and adheres to the surface of the semiconductor chip 4. Therefore, the resin which has a higher dielectric constant than air, is left around the active part of the semiconductor chip 4 and the high frequency characteristic is deteriorated.

The form of the primary sealing resin 6 applied to the semiconductor chip 4 is unstable and the sealing process is complex. In particular, since the lead frame 2 generally has a punched structure, applied liquid resin drips from a punched part because of gravity and it becomes unstable. The semiconductor chip can also be sealed using a metallic mold, however, its process is more complex, compared with the process for applying liquid resin.

Further, since the height of each lead frame 2 in a bump mounted part is not uniform, flip-chip mounting is difficult and when the end of the lead frame 2 is dislocated in a process after the chip is mounted, the bump and the lead are disconnected.

A method by etching or a method by pressing is substantially used to form the lead frame 2. In the method by etching, mass production is difficult and the process is longer, compared with the method by pressing, and thus, the method by pressing is generally used; however, in a process for forming each lead frame 2 by pressing, dispersion in the height between each lead frame 2 occurs by external force by pressing.

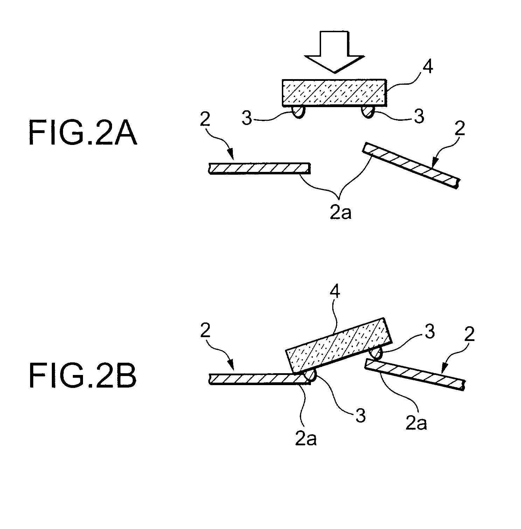

FIGS. 2A and 2B show a state in which dispersion in the height between each lead terminal 2a occurs in the semiconductor device shown in FIGS. 1A to 1D. FIG. 2A is an explanatory drawing when the chip is mounted and FIG. 2B is an explanatory drawing after the chip is mounted. As shown in FIGS. 2A-2B, when the semiconductor chip 4 is mounted as shown in FIG. 2A in a state that it is kept substantially horizontal in case dispersion in the height between the lead terminals 2a occurs, a failure of connection is caused due to difference in a level between the lead terminals 2a as shown in FIG. 2B.

Also, when the end of the lead terminal 2a is dislocated after flip-chip mounting, stress cannot be absorbed differently from connection via flexible wire, and the bump 3 and the lead frame 2 are disconnected.

Therefore, as flip-chip mounting via the bump 3 is normally difficult and the mounting is disabled, deterioration in the yield and others cannot be naturally avoided.

An object of the invention is to provide a semiconductor device wherein a semiconductor chip is prevented from being contaminated by primary sealing resin, no characteristics of the device are deteriorated, no difference in a level by the dislocation of the end of a lead terminal is caused and its manufacturing method.

### SUMMARY OF THE INVENTION

In one embodiment of the present invention, a semiconductor device is provided having a semiconductor chip mounted on a chip mounting part of a lead frame, a resin receiver provided on the side of the rear surface of the chip mounting part, primary sealing resin that seals the semiconductor chip in a range in which the resin receiver is provided so that space is formed between the semiconductor chip and the resin receiver and secondary sealing resin that wraps the primary sealing resin together with the resin receiver and forms double sealed structure.

According to the configuration, the resin receiver is provided on the side of the rear surface of the chip mounting part of the lead frame on which the semiconductor chip is mounted, the semiconductor chip is sealed by the primary sealing resin in the range in which the resin receiver is provided so that the space is formed between the resin receiver and the semiconductor chip and the double sealed structure wrapping the primary sealing resin together with the resin receiver is formed by the secondary sealing resin. Hereby, as the semiconductor chip is prevented from being contaminated by the primary sealing resin, no characteristics of the device are deteriorated and no difference in a level by the dislocation of the end of the lead terminal is caused, and a state that mounting is impossible can be prevented.

Also, the semiconductor device can be manufactured by the method of manufacturing the semiconductor device according to the invention and further, the method of manufacturing the semiconductor device can be executed by production equipment used in the method of the manufacturing the semiconductor device according to the invention.

### BRIEF DESCRIPTION OF THE DRAWINGS

The above and other objects, advantages and features of the present invention will be more apparent from the following description taken in conjunction with the accompanying drawings, in which:
FIGS. 1A to 1D show a semiconductor device provided with conventional type hollow package structure, FIG. 1A is a sectional view and FIGS. 1B to 1D are process drawings explaining a manufacturing method;
FIGS. 2A and 2B show a state that dispersion in the height between lead terminals occurs in the semiconductor device shown in FIGS. 1, FIG. 2A is an explanatory drawing when a chip is mounted and FIG. 2B is an explanatory drawing after the chip is mounted;
FIG. 3 is a sectional view showing a semiconductor device equivalent to one embodiment of the invention;
FIGS. 4A to 4F are sectional views showing a method of manufacturing the semiconductor device shown in FIG. 3;
FIG. 5Aa, FIG. 5Ab, FIG. 5Ba, FIG. 5Bb, FIG. 5Ca, FIG. 5Cb, FIG. 5Da, and FIG. 5Db are explanatory drawings showing a method of applying primary sealing resin shown in FIG. 4F;
FIGS. 6A and 6B are sectional views for explaining the application method used for the application of the primary sealing resin shown in FIG. 4F;
FIGS. 7A to 7C, FIG. 7Da, and FIG. 7Db are explanatory drawings for explaining a needle used in the application method shown in FIGS. 6;
FIGS. 8A to 8D are explanatory drawings showing an example of an element other than a resin tape functions as a resin receiver; and
FIGS. 9A and 9B are explanatory drawings showing an example of an element other than the resin tape shown in FIG. 3 functioning as a resin receiver.

### BRIEF DESCRIPTION OF THE PREFERRED EMBODIMENTS

Referring to the drawings, an embodiment of the invention will be described below.

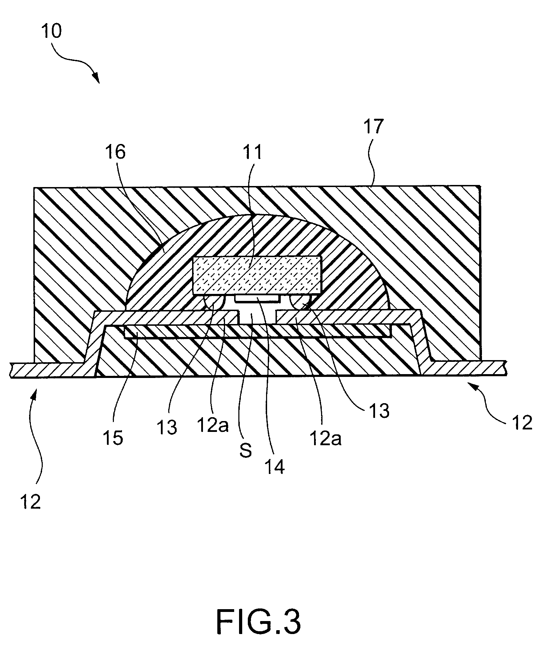

FIG. 3 is a sectional view showing a semiconductor device equivalent to one embodiment of the invention. As shown in FIG. 3, a semiconductor device 10 has a hollow package structure that a semiconductor chip 11 is sealed with resin in a state that space s is formed in a part or the whole between the semiconductor chip 11 and a lead frame 12.

The semiconductor chip 11 is connected to a chip mounting part on the upper surface of the lead frame 12 made of metal, such as copper, and formed by punching via a bump 13 in flip-chip mounting (for example, a case of four terminals is shown).

A wiring pattern 14 is located on the lower surface of the semiconductor chip 11 mounted on the lead frame 12 apart from plural lead terminals 12a and opposite to a clearance (end clearance) formed between the ends of opposite lead terminals 12a.

A resin tape 15 as a resin backing part is stuck in substantially the whole area of the lower surface of the lead terminal 12a, that is, on the rear surface opposite of the chip mounting part so that a punched part of the lead frame 12 including the end clearance is blocked. The upper surface of the lead terminal 12a is sealed with a primary sealing resin 16 so that the bump 13 and the semiconductor chip 11 are wrapped and the primary sealing resin 16 is sealed with a secondary sealing resin 17 so that the primary sealing resin 16 is wrapped together with the lead terminal 12a.

That is, the mount-shaped primary sealing resin 16 for covering the bump 13 and the semiconductor chip 11 is further covered with the secondary sealing resin 17, which also covers the lead frame 12 together with the resin tape 15, and the primary sealing resin and the secondary sealing resin form a double sealed structure.

Therefore, the space s on the lead frame 12 which is formed by the semiconductor chip 11 and the bump 13 and in which the wiring pattern 14 is exposed is sealed by blocking the end clearance formed by the lead terminals 12a with the resin tape 15 and blocking the clearance formed by the bumps 13 with the primary sealing resin 16.

That is, the semiconductor chip 11 is sealed with resin for sealing formed by the primary sealing resin 16 and the secondary sealing resin 17 via the resin tape 15 so that the side of the surface in the vicinity of the wiring pattern 14 is hollow.

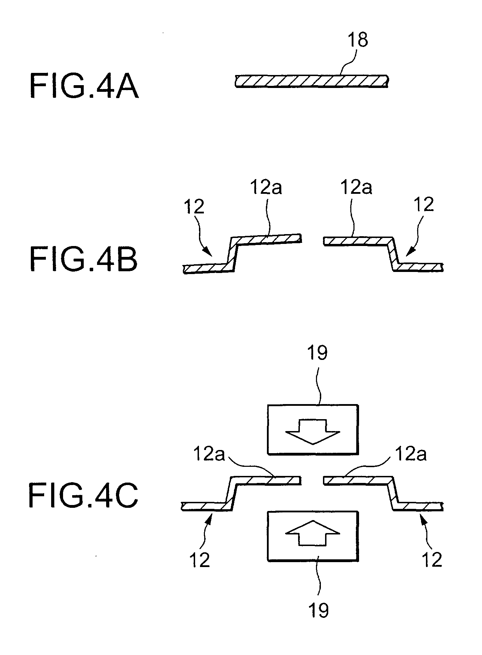

FIGS. 4A to 4F are sectional views showing a method of manufacturing the semiconductor device shown in FIG. 3. As shown in FIGS. 4A to 4F, first, the lead frame 12 is formed by punching or etching a metallic plate 18 shown in FIG. 4A (as shown in FIG. 4B).

Next, the opposite lead terminals 12a are simultaneously put between pressing parts 19 of a press (not shown) from opposing vertical directions shown by arrows in FIG. 4C and are pressed so that each lead terminal 12 is parallel. Hereby, the height of each lead terminal 12a can be substantially equalized.

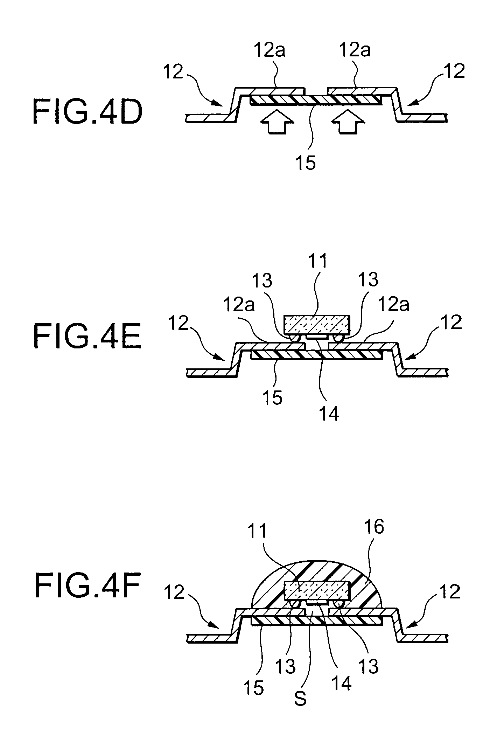

After the opposite lead terminals are pressed so that they are parallel, the resin tape 15 is thermo-compression-bonded on the rear surface of the chip mounting part on which the semiconductor chip 11 is to be mounted, of the lead frame 12 in which each lead terminal 12a is parallel and flat as shown in FIG. 4D. Therefore, the resin tape 15 is stuck on substantially the whole rear surface of each lead terminal 12a, the height of which is unified.

Next, the semiconductor chip 11 is connected to an electrode on the side of the chip mounting part of the lead frame 12 via the bump 13 in flip-chip mounting as shown in FIG. 4E and afterward, the primary sealing resin 16 of low flowability is applied from the top of the semiconductor chip 11 so that the semiconductor chip 11 is covered in a range in which the resin tape 15 is stuck as shown in FIG. 4F.

The primary sealing resin 16 is applied to only an active part opposite to the lead frame 12 of the semiconductor chip 11 connected to the lead frame 12, that is, only the vicinity of the wiring pattern 14 so that a hollow structure in which air is confined is formed. That is, the applied primary sealing resin 16 covers the four sides of the semiconductor chip 11 and the space s is formed between the chip active side (the surface on the side of the wiring pattern 14) of the semiconductor chip 11 and the resin tape 15.

At this time, unless an escape of air from the four sides is simultaneously blocked when air is confined in the space s, the primary sealing resin 16 flows into the vicinity of the chip active part by capillary action. To prevent this inflow, after the semiconductor chip 11 is mounted, the primary sealing resin 16 is applied to the upper surface of the semiconductor chip 11 with high pressure and is isotropically spread to the side of the semiconductor chip 11.

The primary sealing resin 16 required for forming a hollow structure in the vicinity of the active part has low flowability and has a viscosity of approximately 5000 ps. For such resin of low flowability, there is liquid resin such as epoxy resin. An escape of air is prevented from being formed because the primary sealing resin 16 isotropically spreads and in case the primary sealing resin does not spread isotropically, it is applied to each side.

Next, after the primary sealing resin 16 is cured, it is further sealed with the secondary sealing resin 17 so that the secondary sealing resin wraps the primary sealing resin 16 together with both lead terminals 12a and the resin tape 15. The semiconductor chip 11 is sealed together with the primary sealing resin 16 and with the secondary sealing resin 17 as shown in FIG. 3. At this time, the secondary sealing resin 17 is interrupted by the resin tape 15 and the primary sealing resin 16 and never flows into the vicinity of the chip active part.

Therefore, the semiconductor device 10 which has a hollow structure using the lead frame 12 made of metal in the vicinity of the active part of the semiconductor chip 11 and in which the semiconductor chip 11 can be firmly held can be formed.

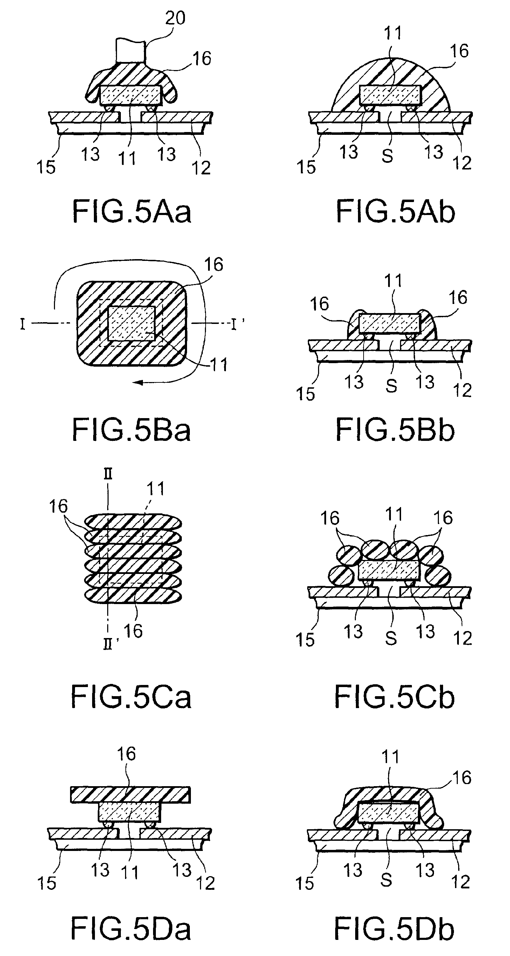

FIGS. 5Aa to 5Db are explanatory drawings showing a method of applying the primary sealing resin 16 shown in FIGS. 4F. Various methods for applying the primary sealing resin 16 of low flowability to the semiconductor chip 11 will be described below.

As shown in FIG. 5Aa, the primary sealing resin 16 is dripped toward the semiconductor chip 11 from a needle 20 located over the semiconductor chip 11 of production equipment (not shown) and covers the whole semiconductor chip 11. Hereby, the semiconductor chip 11 is enclosed with the primary sealing resin 16 and the hollow structure having the space s is formed in the vicinity of the active part, as shown in FIG. 5Ab.

As shown in FIG. 5Ba, the primary sealing resin 16 is dripped toward the semiconductor chip 11, moving the needle (not shown) located over the semiconductor chip 11 along the periphery of the semiconductor chip 11 around the semiconductor chip 11 as shown by an arrow. Hereby, the periphery of the semiconductor chip 11 is enclosed with the primary sealing resin 16 and the hollow structure having the space s is formed in the vicinity of the active part, as shown in FIG. 5Bb. FIG. 5Bb is a sectional view at line II-II' of FIG. 5Ba.

As shown in FIG. 5Ca, the primary sealing resin 16 is dripped from the needle (not shown) so as to be in the shape of a bar located over the semiconductor chip 11 so that the bars are arranged in parallel on the upper surface of the semiconductor chip 11 and covers the whole semiconductor chip 11. Hereby, the semiconductor chip 11 is enclosed with the primary sealing resin 16 and the hollow structure having the space s is formed in the vicinity of the active part, as shown in FIG. 5Cb. FIG. 5Cb is a sectional view at line III-III' of FIG. 5Cb.

As shown in FIG. 5Da, the primary sealing resin 16 made of resin varying from a solid state to a solid state via a liquid state by heating is worked in the shape of a plate, is laid on the upper surface of the semiconductor chip 11 and is heated. The primary sealing resin 16 is softened by heating to cover a chip side and is hardened again. Hereby, the semiconductor chip 11 is enclosed with the primary sealing resin 16 and the hollow structure having the space s is formed in the vicinity of the active part, as shown in FIG. 5Db.

Further, other methods of primary sealing with the primary sealing resin will be described below. The semiconductor device 10 according to the invention has a double sealed structure formed by secondary sealing after primary sealing with resin of low flowability to form the hollow structure.

In the double sealed structure, peeling at an interface between each resin caused by a difference in a coefficient of thermal expansion between each resin, and further, a crack of a package caused by the peeling are general problems. For resin of low flowability for the primary sealing, resin high in a coefficient of thermal expansion is generally used.

To reduce the coefficient of thermal expansion of the resin of low flowability, the percentage content of a filler is required to be increased, however, then the viscosity is increased more than required. Therefore, if resin of low flowability is originally used, it is very difficult to apply resin of low flowability from the upper surface of the chip so that the chip is covered to form a hollow structure because the flowability is extremely reduced when the viscosity is further increased.

Then, to enable the formation of hollow structure even if the viscosity is high as described above, an application method of not dripping resin from the upper surface of the chip but of covering the chip with the needle which is a delivery pipe of resin and enclosing the side of the chip with resin by thrusting resin to the side of the chip is adopted.

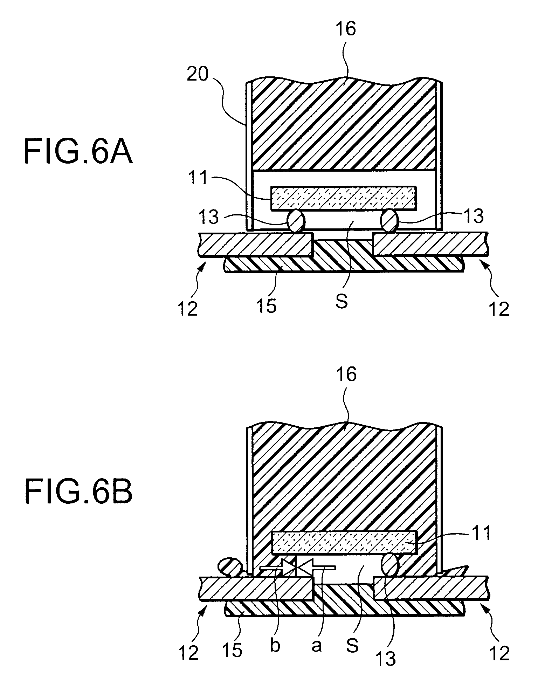

FIGS. 6A and 6B are sectional views for explaining the method of applying the primary sealing resin 16 shown in FIG. 4F. As shown in FIG. 6A, first, the semiconductor chip 11 connected to the lead frame 12 in flip-chip mounting (see FIG. 4E) is located within the inside diameter of the aperture at the end of the needle 20 and the chip 11 is covered with the needle 20. At this time, the end of the aperture of the needle 20 is made substantially in contact with the upper surface of the lead frame 12.

Next, the primary sealing resin 16 of low flowability discharged from the needle 20 is applied by thrusting it to the side of the chip 11. During application, the pressure and the time of the discharge of the primary sealing resin 16 from the needle 20 are adjusted so that the primary sealing resin 16 does not enter the space s. Therefore, the pressure a of an air layer confined in the space s is resistant to the pressure b of the discharge of the primary sealing resin 16, to prevent the primary sealing resin 16 from entering the space s and to form a hollow structure in the vicinity of the active part of the semiconductor chip 11 as shown in FIG. 6B.

As a result, the high frequency characteristic can be improved. The reason is that as the primary sealing resin 16 of low flowability is applied according to the application method so that the semiconductor chip 11 is covered and is not applied on the surface (on the active side) of the semiconductor chip 11, the air layer having a low dielectric constant is formed on the surface of the semiconductor chip 11.

The form of the hollow structure can be stabilized also. The reason is that as the resin tape 15 using polyimide high heat resistant resin, for example, is stuck on the rear side of the punched part of the lead frame 12 and the primary sealing resin 16 is applied from the top after the chip is mounted, the resin tape 15 functions as a receiver of the primary sealing resin 16, that is, a resin receiver to prevent leakage and stable application is enabled.

In addition, as the periphery of the air layer on the surface of the chip is completed covered with the resin tape 15, the primary sealing resin 16 and the surface of the chip, since the resin tape 15 is stuck, external pressure by the primary sealing resin 16 and internal pneumatics are balanced and a stable hollow structure can be formed.

Further, the failure of the connection of the lead frame 12 and the bump 13 in and after flip-chip mounting can be reduced. The reason is that as the lead is pressed, correcting parallelism after the lead is worked and the resin tape 15 is stuck on the rear surface of a bump mounting part of the lead frame 12, dispersion in the height and dislocation between each lead terminal 12a can be inhibited.

According to this application method, the primary sealing resin 16 is applied so that it spreads isotropically toward the semiconductor chip 11 and toward the side of the chip as shown in FIGS. 6A and 6B and the needle 20 used at this time will be described below.

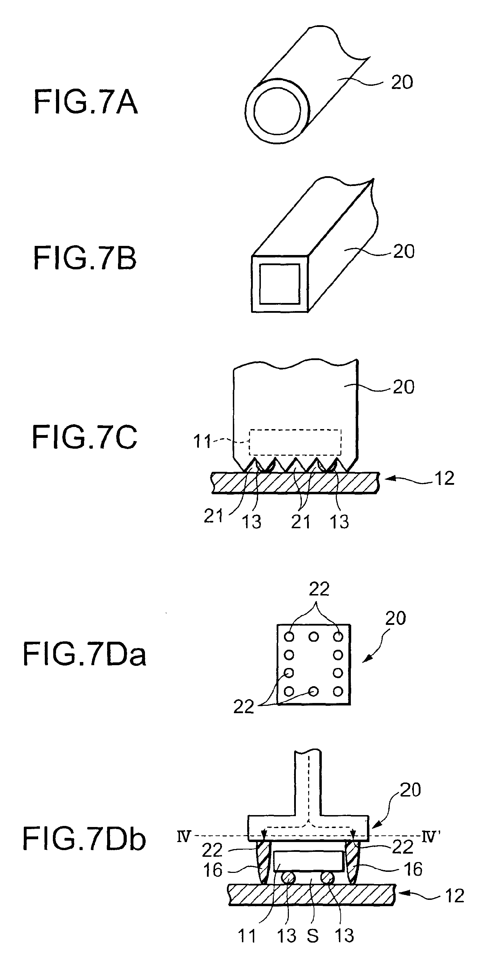

FIGS. 7A to 7Db are explanatory drawings for explaining the needle used for the application method shown in FIGS. 6A and 6B. As shown in FIGS. 7A to 7D, the needle 20 fitted in the size and the form of the semiconductor chip 11 is used and the form of the aperture may be circular as shown in FIG. 7A and rectangular as shown in FIG. 7B.

For the form of the aperture, a clearance 21 where the resin 16 and air can escape may be provided also to the end of the aperture touched to the upper surface of the lead frame 12 as shown in FIG. 7C and further, plural discharge openings 22 may be provided also in the periphery of the end face of the aperture (for example, a rectangular case is shown) so that the resin 16 can be substantially simultaneously applied in the periphery of the chip as shown in FIG. 7Db. FIG. 7Da is a sectional view at line IV-IV' of FIG. 7Db.

The resin tape 15 which functions as a receiver of the primary sealing resin 16 has a two-layer structure of a base material and an adhesive, for the base material. Heat resistant polyimide, for example, is used and for the adhesive, a thermosetting adhesive and a thermoplastic adhesive are used.

In the embodiment, after the resin tape 15 is stuck on the lead frame 12, the semiconductor chip 11 is mounted; however, the resin tape 15 may be stuck after the semiconductor chip 11 is mounted. According to another method which uses no resin tape 15, the primary sealing resin 16 may also function as a receiver.

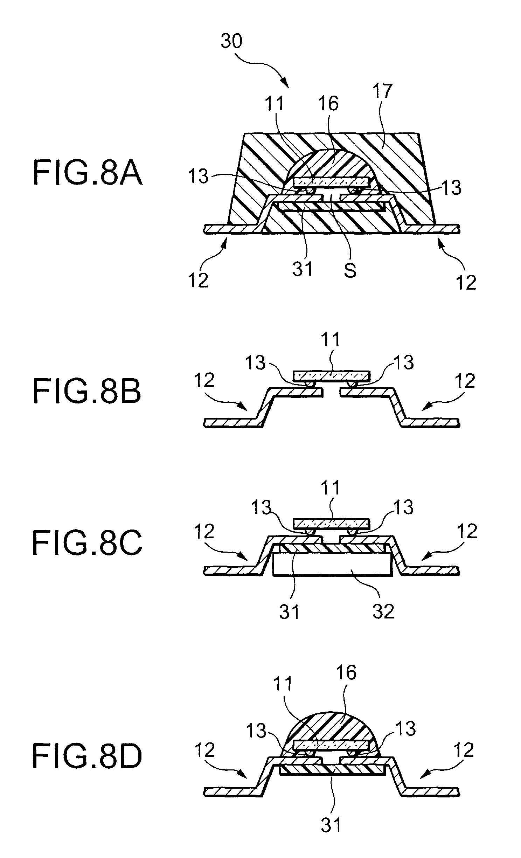

FIGS. 8A to 8D are explanatory drawings showing examples in which elements other than the resin tape shown in FIG. 3 function as a resin receiver. As shown in FIGS. 8A to 8D, a semiconductor device 30 has the similar function and action as those of the semiconductor device 10 shown in FIG. 3 except that a thinly formed backing member 31 is used for a receiver of primary sealing resin 16 as shown in FIG. 8A and a method of manufacturing the semiconductor device 30 is also similar to that of the semiconductor device 10 shown in FIGS. 4A to 4F after the backing member 31 is formed.

In this case, first, after a semiconductor chip 11 is mounted as shown in FIG. 8B, the backing member 31 made of a non-conductive member such as epoxy resin and polyimide resin is arranged on the rear surface of a chip mounting part of a lead frame 12 and is positioned and fixed by a pressing member 32 as shown in FIG. 8C.

Next, a hollow structure having space s is formed by applying the primary sealing resin 16 from the top of the semiconductor chip 11. At this time, the backing member 31 is also kept in an arranged state because of the stickiness of the primary sealing resin 16 after the pressing member 32 is removed and a receiver by the backing member 31 is formed in place of the resin tape 15. Afterward, the primary sealing resin 16 is hardened with the backing member 31 kept as shown in FIG. 8D.

Next, secondary sealing resin 17 seals the semiconductor chip 11 and the primary sealing resin 16 as shown in FIG. 8A. At this time, the secondary sealing resin 17 is interrupted by the backing member 31 and the primary sealing resin 16 and never flows into the vicinity of a chip active part.

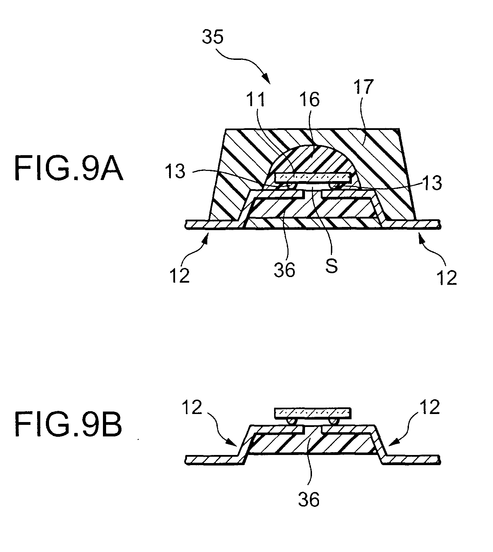

FIGS. 9A and 9B are explanatory drawings showing an example that an element other than the resin tape shown in FIG. 3 functions as a receiver. As shown in FIGS. 9A and 9B, a semiconductor device 35 has the similar function and action to those of the semiconductor device 10 shown in FIG. 3 except that a receiver of primary sealing resin 16 is formed by a backing member 36 integrated with resin as shown in FIG. 9A and a method of manufacturing the semiconductor device 35 is also similar to that of the semiconductor device 10 shown in FIGS. 4A to 4F after a receiver by the backing member 36 is formed.

In this case, first, a receiver by the backing member 36 integrated with sealing resin is formed on the rear surface of a chip mounting part of a lead frame 12 as shown in FIG. 9B in place of the resin tape 15.

Next, the semiconductor chip 11 is mounted via the bump 13 on the lead frame 12 on the rear surface of which the receiver by the backing member 36 is formed and afterward, the hollow structure having the space s is formed by applying primary sealing resin 16 from the top of the semiconductor chip 11. Further, the primary sealing resin 16 is covered with the secondary sealing resin 17, and the semiconductor chip 11 and the primary sealing resin 16 are sealed with the secondary sealing resin 17 as shown in FIG. 9A. At this time, the secondary sealing resin 17 is interrupted by the backing member 36 and the primary sealing resin 16 and never flows into the vicinity of the chip active part.

As described above, according to the invention, the resin receiver such as the resin tape 15 stuck on the rear surface of the chip mounting part of the lead frame 12 is used for a receiver of the primary sealing resin 16 and applied liquid resin (for example, epoxy resin) is prevented from being dripped from the punched part of the metallic lead frame 12.

Hereby, resin is prevented from entering the space s during secondary sealing and the application for forming a hollow structure on the side of the surface of the semiconductor chip 11 of liquid resin can be stably performed.

That is, in the structure in which the semiconductor chip such as a light receiving element is connected to the lead frame on which a film is stuck in a flip-chip mounting, they are double sealed and space is provided between the surface of the chip and each lead, space for preventing resin from dripping on the active part (the operating part) of the semiconductor chip has only to be secured and to secure the space, the vicinity of the active part is made hollow.

Also, synergistic effect that the dislocation of the lead terminal 12a is eliminated and nonuniformity in the height between each terminal of the lead frame 12 can be solved, respectively, by providing the resin receiver that functions as a receiver such as the resin tape 15.

Therefore, the flip-chip mounting of the semiconductor chip 11 via the bump 13 is enabled by providing the resin receiver such as the resin tape 15 and the hollow package of the lead frame 12 on which the semiconductor chip is mounted in flip-chip mounting can be stably manufactured.

In the embodiment, the semiconductor chip 12 is formed in a rectangle and has four sides, however, the form is not limited to this form and the semiconductor chip may be also circular, polygonal or cubic. The lead frame 12 is not limited to the punched one and may be formed by etching.

As described above, according to the invention, as the resin receiver is provided on the side of the rear surface of the chip mounting part of the lead frame on which the semiconductor chip is mounted, the semiconductor chip is sealed by the primary sealing resin in the range in which the resin receiver is provided so that space is formed between the resin receiver and the semiconductor chip and the double sealed structure wrapping the primary sealing resin together with the resin receiver is formed by the secondary sealing resin, the semiconductor chip is prevented from being contaminated by the primary sealing resin and no characteristics of the device are deteriorated, and as no difference in a level is caused by the dislocation of the end of the lead terminal, an unmountable state can be prevented.

Also, the semiconductor device can be manufactured by the method of manufacturing the semiconductor device according to the invention and further, the method of manufacturing the semiconductor device can be executed by production equipment used in the method of manufacturing the semiconductor device according to the invention.

The present invention is not limited to the above embodiments, and it is contemplated that numerous modifications may be made without departing from the spirit and scope of the invention. The package structure, as described above with reference to the drawings, is merely an exemplary embodiment of the invention, and the scope of the invention is not limited to these particular embodiments. Accordingly, other structural configurations may be used, without departing from the spirit and scope of the invention as defined in the following claims.

## Claims

1. A semiconductor device comprising:
a lead frame comprising a mounting part;
a semiconductor chip mounted on a first surface of said mounting part;
a resin receiver provided on a second surface of said mounting part;
a primary sealing resin on said semiconductor chip and said lead frame so that a space is formed between said semiconductor chip and said resin receiver; and
a secondary sealing resin on said primary sealing resin.

2. The semiconductor device as claimed in claim 1, wherein said mounting part is lead terminals.

3. The semiconductor device as claimed in claim 2, wherein said resin receiver is a resin tape, and
wherein said resin tape seals a gap between said lead terminals.

4. The semiconductor device as claimed in claim 3, wherein said resin tape comprises a base material layer and an adhesive layer.

5. The semiconductor device as claimed in claim 4, wherein said base material layer is a polyimide.

6. The semiconductor device as claimed in claim 2, wherein said resin receiver is a backing member, and
wherein said backing member seals a gap between said lead terminals.

7. The semiconductor device as claimed in claim 6, wherein said backing member is an epoxy resin.

8. The semiconductor device as claimed in claim 1, further comprising:
a bump connecting said semiconductor chip and said mounting part.

9. The semiconductor device as claimed in claim 1, wherein said secondary resin is provided on said resin receiver.

10. The semiconductor device as claimed in claim 9, wherein said secondary resin is formed on a surface of said lead frame except said mounting part.

11. A method of manufacturing a semiconductor device comprising steps of:
providing a lead frame having a mounting part;
providing a resin receiver on a rear surface of said mounting part;
mounting a semiconductor chip on a front surface of said mounting part;
sealing said semiconductor chip and said lead frame so that a space is formed between said semiconductor chip and said resin receiver with a primary resin; and
sealing said primary resin with a secondary resin.

12. The method of manufacturing a semiconductor device as claimed in claim 11, wherein said step of sealing, further comprises steps of:
providing said primary resin along an edge of said semiconductor chip; and
heating said primary resin to seal said semiconductor chip and said lead frame.

13. The method of manufacturing a semiconductor device as claimed in claim 11, wherein said step of sealing, further comprises steps of:
providing said primary resin around a middle of a top surface of said semiconductor chip; and
heating said primary resin to seal said semiconductor chip and said lead frame.

14. The method of manufacturing a semiconductor device as claimed in claim 11, further comprising steps of:
arranging a plate resin on said semiconductor chip; and
heating said plate resin to flow on said semiconductor chip and said lead frame to form said primary resin.

15. The method of manufacturing a semiconductor device as claimed in claim 11, wherein said step of sealing, further comprises steps of:
providing said primary resin on each side surface and top surface of said semiconductor device substantially simultaneously; and
heating said primary resin to seal said semiconductor chip and said lead frame.

16. The method of manufacturing a semiconductor device as claimed in claim 11, wherein said secondary resin is formed on a surface of said lead frame except said mounting part.

17. The method of manufacturing a semiconductor device as claimed in claim 16, wherein said secondary resin is provided on said resin receiver.

18. The method of manufacturing a semiconductor device as claimed in claim 11, wherein said mounting part is lead terminals.

19. The method of manufacturing a semiconductor device as claimed in claim 18, further comprising a step of:
pressing said lead terminals so that lead said terminals are arranged in parallel with each other.

20. The method of manufacturing a semiconductor device as claimed in claim 19, wherein said semiconductor chip is connected to said mounting part with a bump.
